# EUROPEAN PATENT APPLICATION

(11) **EP 1 458 021 A2**
(43) Date of publication of application: **15.09.2004**
(21) Application number: 04251084.2
(22) Date of filing: 26.02.2004
(51) Int. Cl.: H01L 21/784, H01L 21/68

(54) **Semiconductor device fabrication method**

(30) Priority: 06.03.2003 JP 2003060303
(71) Applicant: Shinko Electric Industries Co., Ltd., Nagano-shi, Nagano 381-2287 (JP)
(72) Inventor: Sunohara, Masahiro, Nagano-shi, Nagano 381-2287 (JP); Murayama, Kei, Nagano-shi, Nagano 381-2287 (JP)
(74) Representative: Mounteney, Simon James

(57) **Abstract**

A semiconductor device fabrication method for reliably separating diced semiconductor chips (15) from a dicing tape (10) without damaging the diced semiconductor chip. The method includes the steps of: attaching a wafer (11) on a dicing tape; dicing the wafer., thereby forming divided semiconductor chips; and separating the semiconductor chips from the dicing tape, wherein the step of separating includes the steps of: providing a hollow sheet (16A, 16B, 16C) having at least one aperture (18) corresponding to the semiconductor chips between the semiconductor chips attached on the dicing tape and a porous plate (21) coupled to a vacuum source (23); sucking the semiconductor chips to the porous plate via the hollow sheet by driving the vacuum source; and separating the dicing tape from the semiconductor chips under a condition where the semiconductor chips are being sucked to the porous plate.

## Description

### BACKGROUND OF THE INVENTION

### 1. Field of the Invention

The present invention generally relates to a semiconductor device fabrication method, and more particularly to a semiconductor device fabrication method having a step of separating diced semiconductor chips from a dicing tape.

### 2. Description of the Related Art

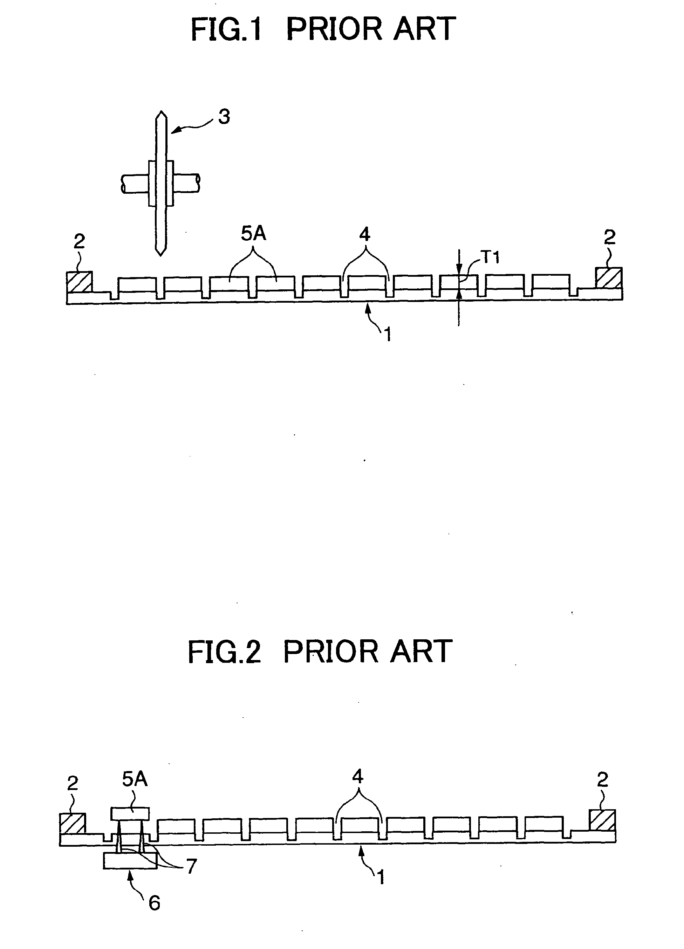

FIG. 1 shows an exemplary dicing step of a conventional semiconductor device fabrication process.

Referring to FIG. 1, a wafer having circuits formed through a predetermined wafer process is mounted on a dicing machine under a condition where the wafer is attached on a dicing tape 1 of a dicing ring 2. Then, the mounted wafer is diced with a dicing saw 3 to form dicing grooves 4 that reach the dicing tape 1, thereby resulting in diced semiconductor chips 5A.

FIG. 2 shows an exemplary pickup step of a conventional semiconductor device fabrication process. In this pickup step, the diced semiconductor chips 5A are separated from the dicing tape 1.

Specifically, an ultraviolet ray is radiated in advance to reduce adhesion force of an adhesive applied on the dicing tape 10. Under this condition, a pickup tool 6 having protrusion pins 7 is pushed up to pierce the dicing tape 1 from the rear surface of the dicing tape 1. At this time, a semiconductor chip 5A is protruded in touch with the protrusion pins 7, thereby separating the semiconductor chip 5A from the dicing tape 1.

Japanese Laid-Open Patent Application No. 11-054594 discloses another method of separating a semiconductor chip from a dicing tape. In the disclosed method, a plurality of diced semiconductor chips are attached on a dicing tape, and the dicing tape having the attached semiconductor chips is mounted on a platform on which a plurality of suction grooves are formed. Here, each of the semiconductor chips is supported at the outer circumference thereof by protrusions between adjacent suction grooves.

Under this condition, negative pressure is applied to the individual suction grooves in order to suck the dicing tape. As a result, since the dicing tape is sucked toward the interiors of the suction grooves under the condition where the semiconductor chips are supported by the protrusions, it is possible to separate the semiconductor chips from the dicing tape.

In recent years, as an electronic device having a semiconductor device is made smaller and thinner, it becomes desirable to make the semiconductor device smaller and thinner. This demand also fosters a tendency to make a semiconductor chip incorporated in such a semiconductor device smaller and thinner. In order to reduce the thickness of a wafer having circuits up to less than 300 µm (about 100 µm), for example, the wafer is grinded from the rear surface thereof (back-grinding).

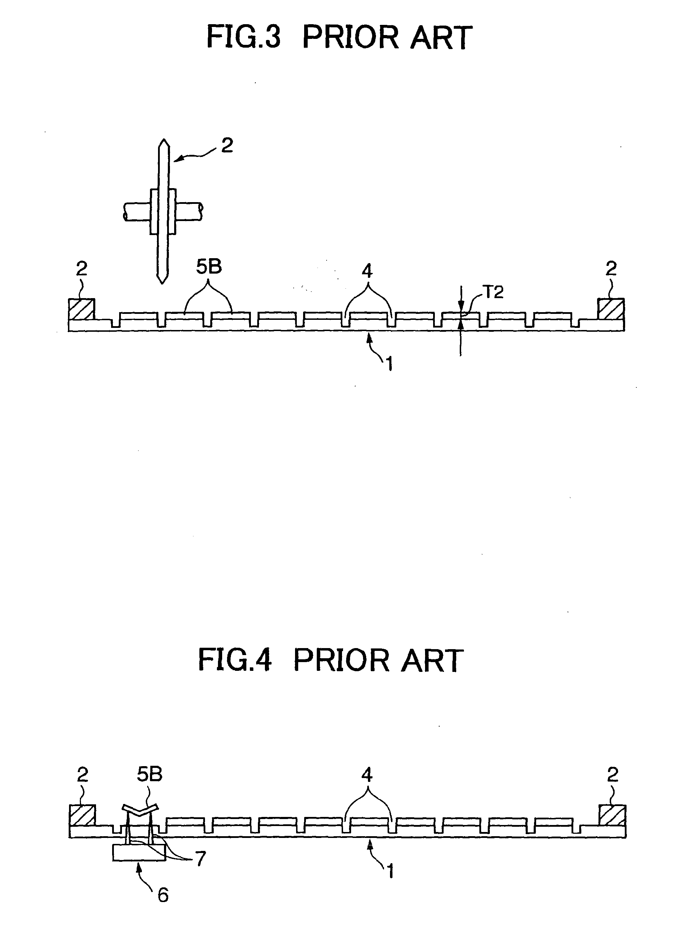

FIG. 3 shows an exemplary conventional step of dicing such a thin wafer.

Referring to FIG. 3, a thin wafer (semiconductor chip 5B) has a thickness T2 substantially smaller than a thickness T1 of the wafer (semiconductor chip 5A) illustrated in FIG. 1 (T2<T1).

In the dicing step shown in FIG. 3, the wafer is diced under a condition where the wafer is attached on the dicing tape 1, that is, where the wafer is supported by the dicing tape 1. As a result, it is possible to prevent the diced semiconductor chips 5B from being damaged during dicing of the wafer.

In accordance with a conventional method in which the pickup tool 6 is used to protrude the semiconductor chips 5B, however, when the protrusion pins 7 push up the wafer, there is a risk that the semiconductor chips 5B may be damaged as illustrate in FIG. 4 because of low physical intensity of the thin wafer.

Furthermore, a diced semiconductor chip is supported only at the outer circumference thereof in the disclosed semiconductor chip separation method. Thus, when a dicing tape is released from the diced semiconductor chip, release intensity arises at the center of the semiconductor chip. As a result, there is a risk that the semiconductor chip may be damaged during separation of the semiconductor chip from the dicing tape.

### SUMMARY OF THE INVENTION

It is a general object of the present invention to provide a semiconductor device fabrication method in which the above-mentioned problems are eliminated.

A more specific object of the present invention is to provide a semiconductor device fabrication method that can reliably separate a diced semiconductor chip from a dicing tape without damaging the diced semiconductor chip.

In order to achieve the above-mentioned objects, there is provided according to one aspect of the present invention a method of fabricating a semiconductor device, including the steps of: attaching a wafer on a dicing tape; dicing the wafer, thereby forming divided semiconductor chips; and separating the semiconductor chips from the dicing tape, wherein the step of separating includes the steps of: providing a hollow sheet having at least one aperture corresponding to the semiconductor chips between the semiconductor chips attached on the dicing tape and a porous plate coupled to a vacuum source; sucking the semiconductor chips to the porous plate via the hollow sheet by driving the vacuum source; and separating the dicing tape from the semiconductor chips under a condition where the semiconductor chips are being sucked to the porous plate.

According to one aspect of the present invention, the semiconductor chips can be supported on the porous plate by sucking the semiconductor chips toward the porous plate. Then, the dicing tape is separated from the semiconductor chips under the condition. As a result, it is possible to reliably separate the dicing tape from the thin semiconductor chips having low physical intensity without damaging the semiconductor chips.

In addition, since the hollow sheet is configured to have at least one aperture corresponding to the semiconductor chips, a vacuum cannot be leaked from a blade groove formed between adjacent semiconductor chips through dicing. As a result, it is possible to reliably vacuum-suck the semiconductor chips toward the porous plate by disposing the semiconductor chips between the hollow sheet and the porous plate.

In an embodiment of the present invention, the method may further include the step of: further providing a porous film between the hollow sheet and the porous plate.

According to one aspect of the present invention, since the porous film is provided between the hollow sheet and the porous plate, the semiconductor chips cannot be directly touched with the porous plate. As a result, it is possible to prevent contamination of the semiconductor chips.

In an embodiment of the present invention, the method may further include the step of: further providing a protective film to protect circuit formation portions of the semiconductor chips between the semiconductor chips and the porous plate.

According to one aspect of the present invention, since the protective film is formed between the semiconductor chips and the porous plate, the protective film can protect-circuit formation portions of the semiconductor chips. As a result, it is possible to prevent contamination of the circuit formation portions.

Other objects, features and advantages of the present invention will become more apparent from the following detailed description when read in conjunction with the accompanying drawings.

### BRIEF DESCRIPTION OF THE DRAWINGS

FIG. 1 shows an exemplary conventional step of dicing a thick wafer;
FIG. 2 shows an exemplary conventional step of picking up thick semiconductor chips;
FIG. 3 shows an exemplary conventional step of dicing a thin wafer;
FIG. 4 shows an exemplary conventional step of picking up thin semiconductor chips;
FIG. 5 is a plan view illustrating an exemplary condition where a wafer is attached on a dicing tape according to a first embodiment of the present invention;
FIG. 6 is a cross-sectional view illustrating an exemplary condition where a wafer is attached on a dicing tape according to the first embodiment;
FIG. 7 is a cross-sectional view illustrating a step of dicing a wafer according to the first embodiment;
FIG. 8 is a plan view illustrating an exemplary condition where the dicing step is completed according to the first embodiment;
FIG. 9 is a cross-sectional view illustrating a step of sucking semiconductor chips toward a suction tool according to the first embodiment;
FIG. 10 is a cross-sectional view illustrating a step of separating a dicing tape according to the first embodiment;
FIGS. 11A through 11C are diagrams to explain types of hollow sheets according to the first embodiment;
FIG. 12 is a cross-sectional view illustrating a step of sucking semiconductor chips toward a suction tool according to a second embodiment of the present invention;
FIG. 13 is a cross-sectional view illustrating a step of separating a dicing tape according to the second embodiment;
FIG. 14 is a cross-sectional view illustrating a step of attaching a mask member on a wafer according to a third embodiment of the present invention;
FIG. 15 is a plan view illustrating an exemplary condition where a dicing step is completed according to the third embodiment;
FIG. 16 is a cross-sectional view illustrating a step of sucking semiconductor chips toward a suction tool according to the third embodiment; and
FIG. 17 is a cross-sectional view illustrating a step of separating a dicing tape from semiconductor chips according to the third embodiment.

### DETAILED DESCRIPTION OF THE PREFERRED EMBODIMENTS

In the following, embodiments of the present invention will be described with reference to the accompanying drawings.

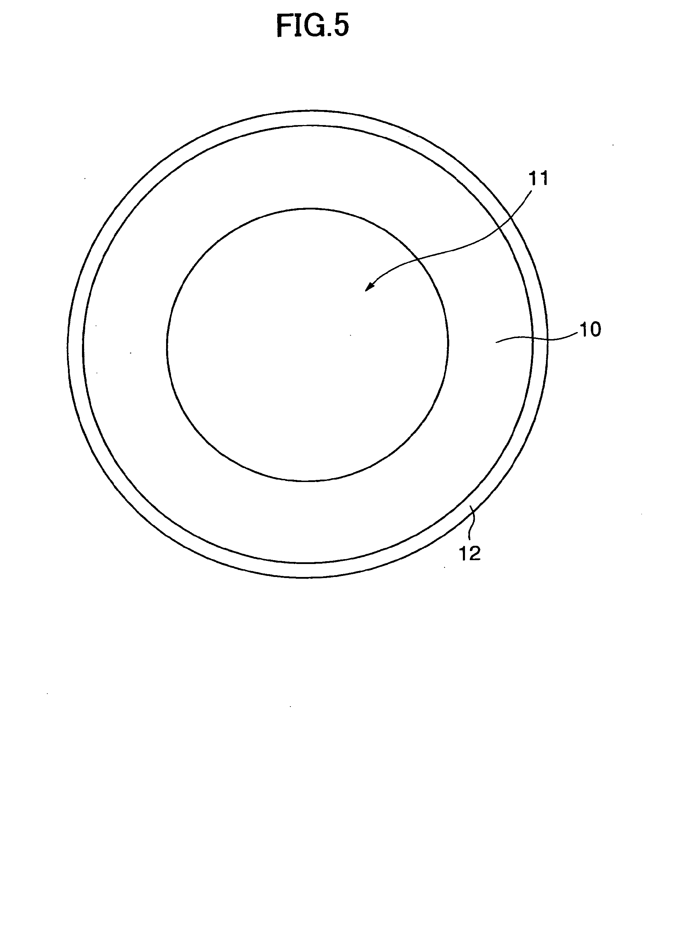

A semiconductor device fabrication method according to a first embodiment of the present invention is described with reference to FIG. 5 through FIG. 10.

FIG. 5 through FIG. 10 are diagrams to explain a semiconductor device fabrication method according to the first embodiment.

The first embodiment has a feature on a step of separating diced semiconductor chips from a dicing tape after a wafer dicing step. In the following embodiments, known fabrication methods may be adopted for the other fabrication steps.

In this specification, the following three fabrication steps are focused: an attaching step of attaching a wafer 11 on a dicing tape 10; a dicing step of forming diced semiconductor chips 15 from the wafer 11; and a separating step of separating the semiconductor chips 15 from the dicing tape 10 after the dicing step.

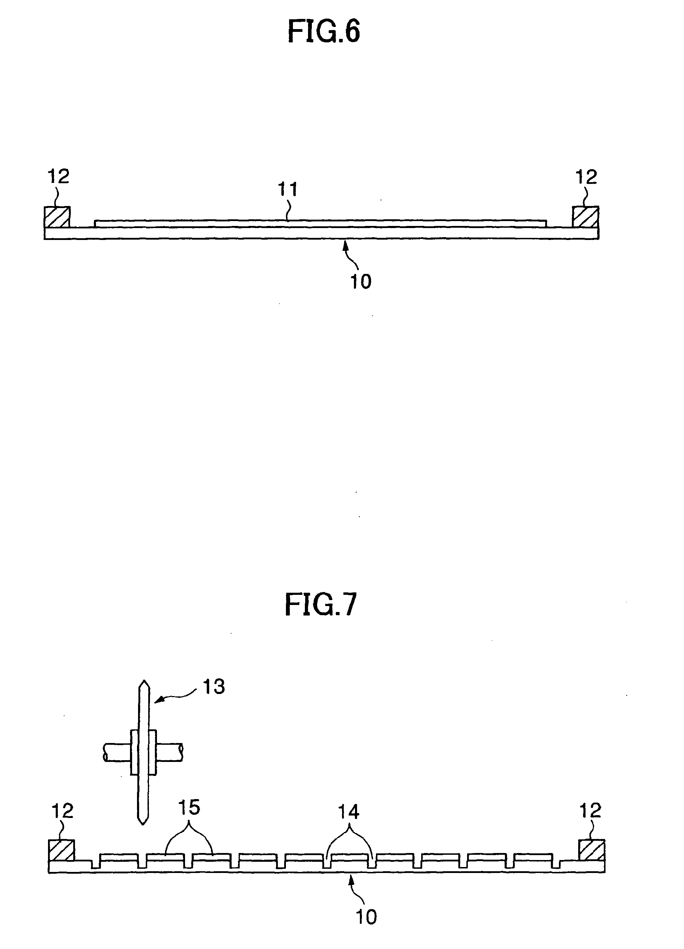

Referring to FIG. 5 and FIG. 6, the wafer 11 is attached on the dicing tape 10. An ultraviolet cure adhesive is coated on one surface of the dicing tape 10. The dicing tape 10 is provided to a ring-shaped metal dicing ring.

After circuits are formed on the wafer 11 through a predetermined wafer process and the circuit formed wafer 11 is back-grinded to make the wafer 11 thinner, the thinner wafer 11 is attached on the dicing tape 10. At this time, the wafer 11 is attached in such a way that the circuit formed surface is faced in the upper direction, in other words, the surface on which the circuits are not formed is in touch with the dicing tape 10.

After the attachment of the wafer 11 on the dicing tape 10, the wafer 11 is mounted on a dicing machine to dice the wafer 11 by using a dicing saw 13. The wafer 11 attached on the dicing tape 10 is diced with the dicing saw 13 so that dicing grooves 14 can be formed to reach the dicing tape 10.

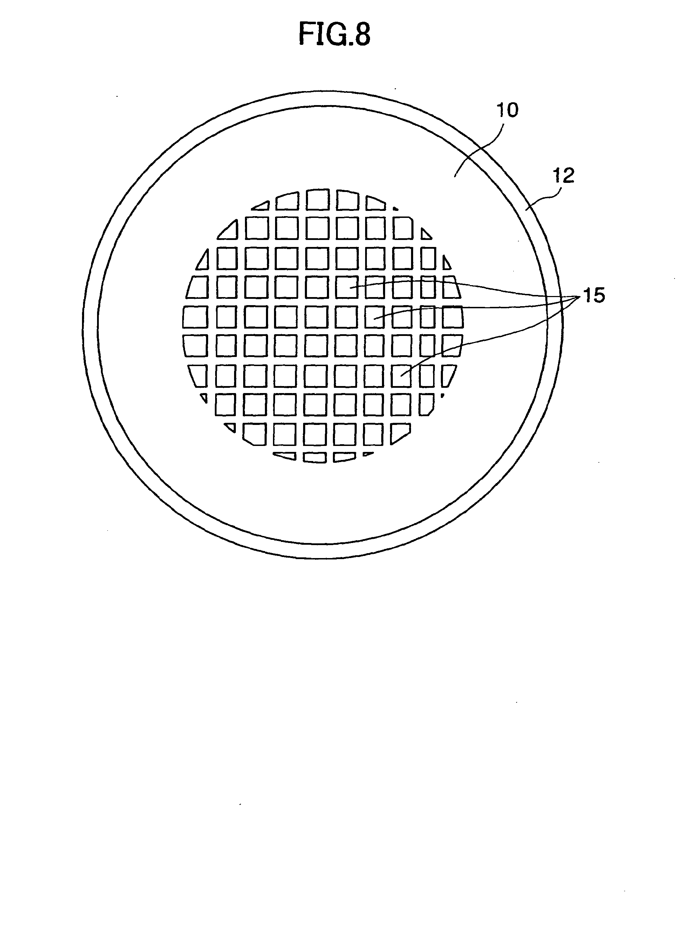

In this fashion, it is possible to divide the wafer 11 into individual semiconductor chips 15 as illustrated in FIG. 8. Here, since the diced semiconductor chips 15 are kept being attached on the dicing tape 10, the positions of the semiconductor chips 15 remain unchanged.

After the dicing step, an ultraviolet ray is radiated on the dicing tape 10 to harden an adhesive applied on the surface of the dicing tape 10 and reduce the adhesive intensity thereof. Then, after the ultraviolet radiation, the separating step of separating the semiconductor chips 15 from the dicing tape 10 is started.

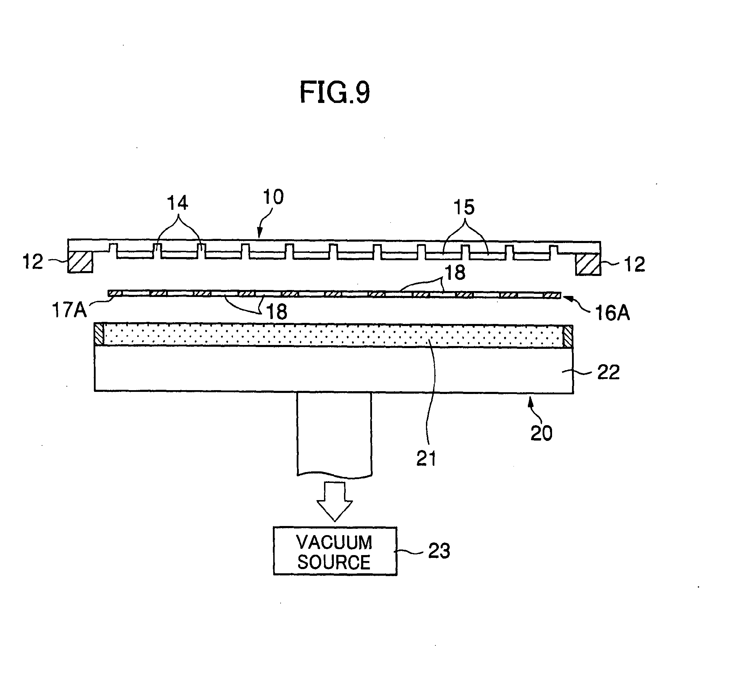

In the separating step, a suction tool 20 is used as illustrated in FIG. 9. The suction tool 20 includes a porous plate 21 at the upper side of a tool body 22. For example, the porous plate 21 may be formed of porous alumina. Also, the suction tool 20 is coupled to a vacuum source 23 to apply negative pressure to the porous plate 21.

The orientation of the semiconductor chips 15 is changed to face the porous plate 21 under the condition where the semiconductor chips 15 are attached to the dicing tape 10. Then, the semiconductor chips 15 are mounted on the suction tool 20. At this time, a hollow sheet 16A is provided between the semiconductor chips 15 and the porous plate 21, as illustrated in FIG. 9.

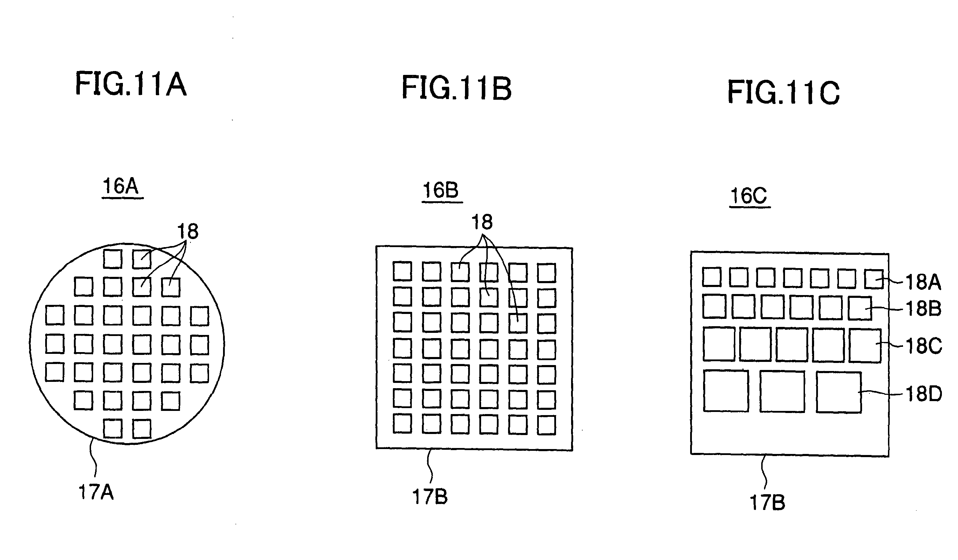

FIG. 11A is a plan view of an exemplary structure of the hollow sheet 16A.

Referring to FIG. 11A, the hollow sheet 16A is configured by forming a plurality of apertures 18 in a circular base sheet 17A. For example, the circular base sheet 17A may be formed of a resin film, silicon and a metal film. The circular base sheet 17A is configured to have a thickness ranging between 20 µm and 200 µm, for example. Such apertures 18 can be formed in the circular base sheet 17A through photolithography, etching, laser processing or other techniques.

Also, the apertures 18 are positioned corresponding to the positions of the semiconductor chips 15 attached on the dicing tape 10. In other words, the apertures 18 are formed such that when the semiconductor chips 15 are touched with the porous plate 21 via the hollow sheet 16A, the apertures 18 can face the semiconductor chips 15.

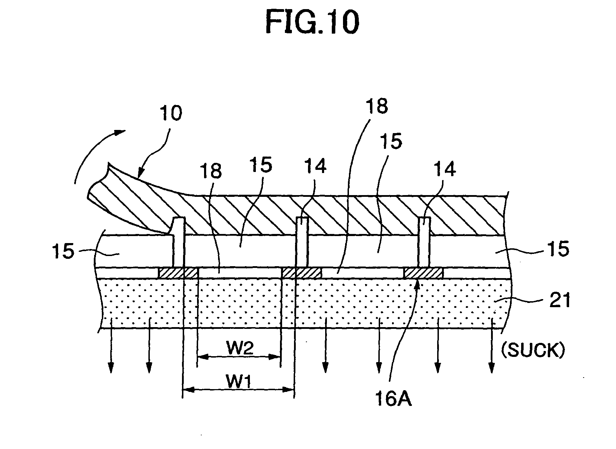

Each of the apertures 18 has a size slightly smaller than that of the semiconductor chip 15. Specifically, if the length of a side of the semiconductor chip 15 is represented as W1 and the length of a side of the aperture 18 is represented as W2, the aperture 18 is formed such that W2 is smaller than W1 (W2 < W1) as illustrated in FIG. 10. In this configuration, when the semiconductor chips 15 are touched with the porous plate 21 via the hollow sheet 16A, the dicing grooves 14, which are formed between adjacent semiconductor chips 15 at the dicing step, are covered with the hollow sheet 16A.

After the semiconductor chips 15 on the dicing tape 10 are mounted on the suction tool 20 via the hollow sheet 16A, the vacuum source 23 is driven to apply negative pressure to the porous plate 21. Due to the negative pressure, the semiconductor chips 15 are sucked toward the porous plate 21 via the hollow sheet 16A.

This suction power is applied to almost entire surfaces of the semiconductor chips 15 via the apertures 18 of the hollow sheet 16A. Although each semiconductor chip 15 is partially supported in accordance with conventional separation methods, the almost entire surface of the semiconductor chip 15 is sucked toward the porous plate 21 in accordance with the inventive separation method. As a result, it is possible to support the almost entire surface of each semiconductor chip 15 on the porous plate 21 (suction tool 20).

As mentioned above, since the dicing grooves 14 are covered with the hollow sheet 16A, no vacuum is leaked from the dicing grooves 14. As a result, it is possible to reliably suck and support the diced semiconductor chips 15 on the porous plate 21 via the hollow sheet 16A.

According to the first embodiment, even if the semiconductor chips 15 are formed as thinner semiconductor chips having low physical intensity, it is possible to reliably separate the semiconductor chips 15 from the dicing tape 10 without damaging the semiconductor chips 15. As a result, it is possible to improve the yield ratio of the semiconductor chips 15.

Also, in order to pick up (carry) the separated semiconductor chips 15 from the suction tool 20, the semiconductor chips 15 may be carried to a carrier by stopping the vacuum source 23 or reducing the suction power of the vacuum source 23.

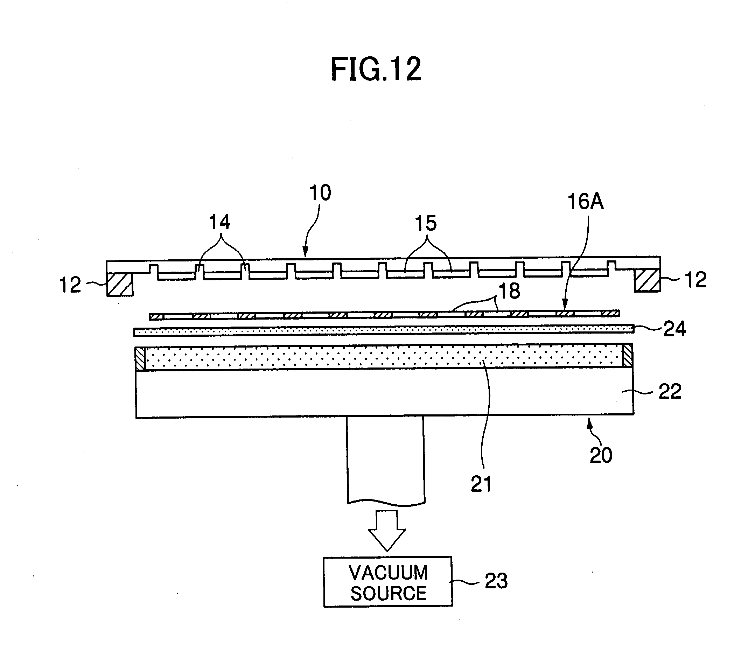

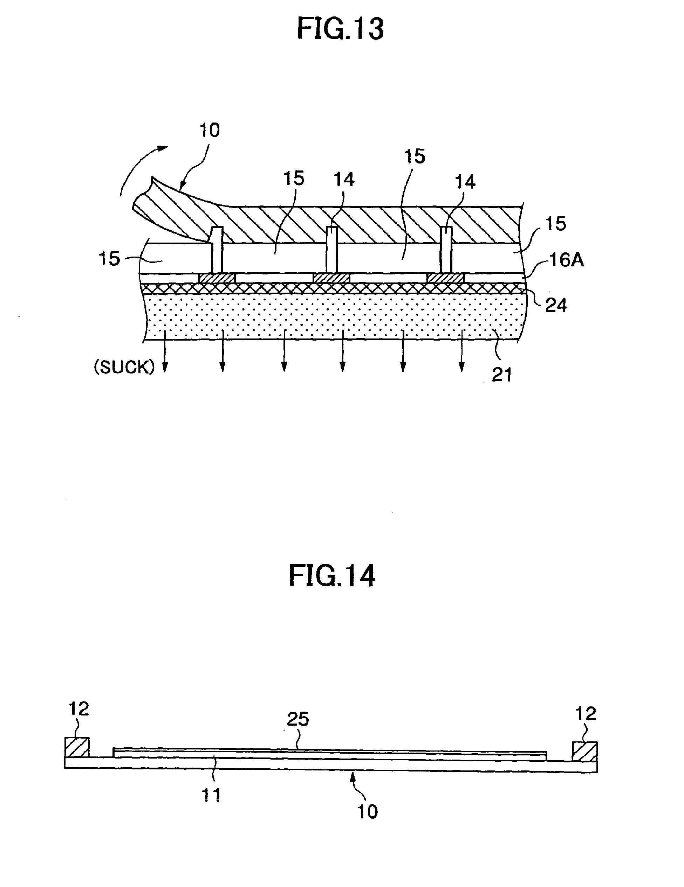

A semiconductor device fabrication method according to a second embodiment of the present invention is described with reference to FIG. 12 and FIG. 13.

FIG. 12 and FIG. 13 are diagrams to explain a semiconductor device fabrication method according to the second embodiment. In FIG. 12 and FIG. 13, the same parts as those shown in FIG. 5 through FIG. 11 are designated by the same reference numerals, and the description thereof is omitted.

As mentioned above, only the hollow sheet 16A is provided between the semiconductor chips 15 and the porous plate 21 in the first embodiment, as illustrate in FIG. 9. In the second embodiment, a porous film 24 is further provided between the hollow sheet 16A and the porous plate 21, as illustrated in FIG. 12.

Referring to FIG. 12 and FIG. 13, the porous film 24 may be formed of polyethylene, polypropylene or the like. Since the porous film 24 is porous like the porous plate 21, the porous film 24 makes it possible to apply negative pressure generated from the vacuum source 23 to the semiconductor chips 15.

As mentioned above, if the porous film 24 is provided between the hollow sheet 16A and the porous plate 21, the semiconductor chips 15 are not directly touched with the porous plate 21. As a result, it is possible to prevent contamination of the semiconductor chips 15 due to the touch of the semiconductor chips 15 with the porous plate 21.

In general, the porous plate 21 having a size corresponding to the wafer 11 is mounted to the suction tool 20. Thus, it is difficult to frequently clean the porous plate 21. On the other hand, the porous film 24 can be easily replaced with another one because of affordability thereof.

According to the second embodiment, the contamination caused by touching the semiconductor chips 15 with the porous plate 21 can be prevented. As a result, it is possible to make the step of cleaning the semiconductor chips 15 unnecessary. In addition, since the porous plate 21 does not have to be cleaned so frequently, it is possible to improve efficiency of the separation step of separating the dicing tape 10.

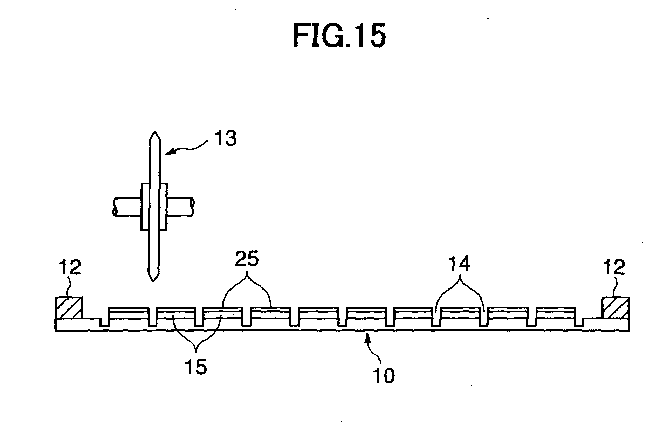

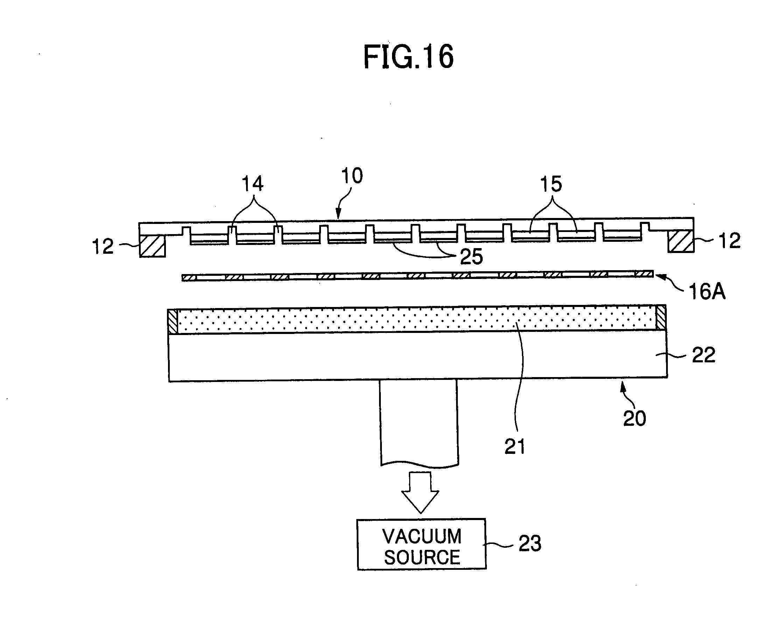

A semiconductor device fabrication method according to a third embodiment of the present invention is described with reference to FIG. 14 through FIG. 17.

FIG. 14 through FIG. 17 are diagrams to explain a semiconductor device fabrication method according to the third embodiment. In FIG. 14 through FIG. 17, the same parts as those shown in FIG. 5 through FIG. 11 are designated by the same reference numerals, and the description thereof is omitted.

In the third embodiment, a mask member 25 is provided on the circuit formed surface of the wafer 11 before or after attachment of the wafer 11 on the dicing tape 10.

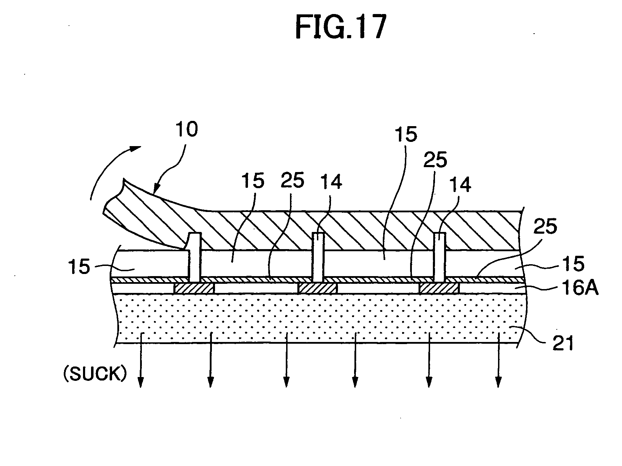

Referring to FIG. 14 and FIG. 17, a back grind tape (BG tape) or a polyvinyl alcohol film (PVA film) may be used as the mask member 25.

If a BG tape for back-grinding is used as mask member 25, the wafer 11 is attached on the dicing tape 10 without separation of the BG tape after the back grinding. As a result, it is possible to easily provide the mask member 25 on the wafer 11 and omit the BG tape separation step required for conventional fabrication processes.

On the other hand, if a PVA film is used as mask member 25, the PVA film is formed on the wafer 11 after attachment of the wafer 11 on the dicing tape 10, for example, by spin-coating PVA on the wafer 11.

After the mask member 25 is provided on the wafer 11 in this fashion, a dicing step is started. In the dicing step, the wafer 11 together with the mask member 25 is diced with the dicing saw 13. Thus, the circuit formed surfaces of the diced semiconductor chips 15 are covered with the mask member 25 after the dicing step.

Subsequently, like the first embodiment (ref. FIG. 9), the hollow sheet 16A is provided between the semiconductor chips 15 and the porous plate 21. Under this configuration, the semiconductor chips 15 attached on the dicing tape 10 are mounted on the suction tool 20. As a result, the mask member 25 is located between the semiconductor chips 15 and the porous plate 16A, as illustrated in FIG. 17.

According to the third embodiment, the semiconductor chips 15 cannot be directly touched with the porous plate 21 by providing the mask member 25 between the semiconductor chips 15 and the hollow sheet 16A. As a result, it is possible to prevent contamination due to the touch of the semiconductor chips 15 with the porous plate 21.

In addition, the third embodiment does not also require the step of cleaning the semiconductor chips 15. Furthermore, since the porous plate 21 does not have to be cleaned so frequently, it is possible to improve efficiency of the separation step of the semiconductor chips 15 from the dicing tape 10.

Also, the mask member 25 provided to the semiconductor chips 15 is removed after the semiconductor chips 15 are picked up. Specifically, if a BG tape is used as the mask member 25, the tape separation process is conducted on the BG tape. On the other hand, if a PVA film is used as the mask member 25, the mask member 25 is removed through water cleaning.

In the above-mentioned embodiments, the description is focused on the hollow sheet 16A as illustrated in FIG. 11A. However, the hollow sheet 16A according to the present invention is not limited to such an illustrated structure. Depending on conditions where the semiconductor chips 15 are attached on the dicing tape 10, the hollow sheet 16A can be configured to have other suitable structures.

For example, the hollow sheet 16B shown in FIG. 11B is configured by forming apertures 18 in a rectangular base sheet 17B. Also, the hollow sheet 16C shown in FIG. 11C is configured corresponding to the semiconductor chips 15 having various sizes. In other words, apertures 18A through 18D having different sizes are formed in the rectangular base sheet 17B.

The present invention is not limited to the specifically disclosed embodiments, and variations and modifications may be made without departing from the scope of the present invention.

The present application is based on Japanese priority application No. 2003-060303 filed March 6, 2003, the entire contents of which are hereby incorporated by reference.

## Claims

1. A method of fabricating a semiconductor device, **characterized by** the steps of:
attaching a wafer (11) on a dicing tape (10);
dicing the wafer, thereby forming semiconductor chips (15) ; and
separating the semiconductor chips from the dicing tape,
wherein the step of separating includes the steps of: providing a hollow sheet (16A, 16B, 16C) having at least one aperture (18) corresponding to the semiconductor chips between the semiconductor chips attached on the dicing tape and a porous plate (21) coupled to a vacuum source (23); sucking the semiconductor chips to the porous plate via the hollow sheet by driving the vacuum source; and separating the dicing tape from the semiconductor chips under a condition where the semiconductor chips are being sucked to the porous plate.

2. A method as claimed in claim 1, further including the step of:
further providing a porous film (24) between the hollow sheet and the porous plate.

3. A method as claimed in claim 1, further including the step of:
further providing a protective film (25) to protect circuit-formed portions of the semiconductor chips between the semiconductor chips and the porous plate.
